# EUROPEAN PATENT SPECIFICATION

(11) **EP 1 643 507 B1**
(45) Date of publication and mention of the grant of the patent: **31.08.2011**
(21) Application number: 05028075.9
(22) Date of filing: 27.07.1998
(51) Int. Cl.: G11C 7/20, H03K 19/177

(54) **Static random access memory circuits**
Statische RAM-Schaltungen
Circuits à mémoire vive statique

(30) Priority: 19.08.1997 US 56165 P; 11.03.1998 US 38123
(43) Date of publication of application: 05.04.2006
(62) Divisional of application: 98305966.8
(73) Proprietor: Altera Corporation, San Jose, CA 95134 (US)
(72) Inventor: Lee, Andy, San Jose CA 95129 (US)
(74) Representative: Gillard, Matthew Paul

(56) References cited:
- EP-A2- 0 618 590
- US-A- 4 870 302
- US-A- 5 325 325
- US-A- 5 361 232
- US-A- 5 561 631

## Description

### Background of the Invention

This invention relates to static random access memory circuits, and more particularly to static random access memory circuits that are especially suitable for such purposes as inclusion on programmable logic integrated circuit devices for programmable control of the configuration of those devices.

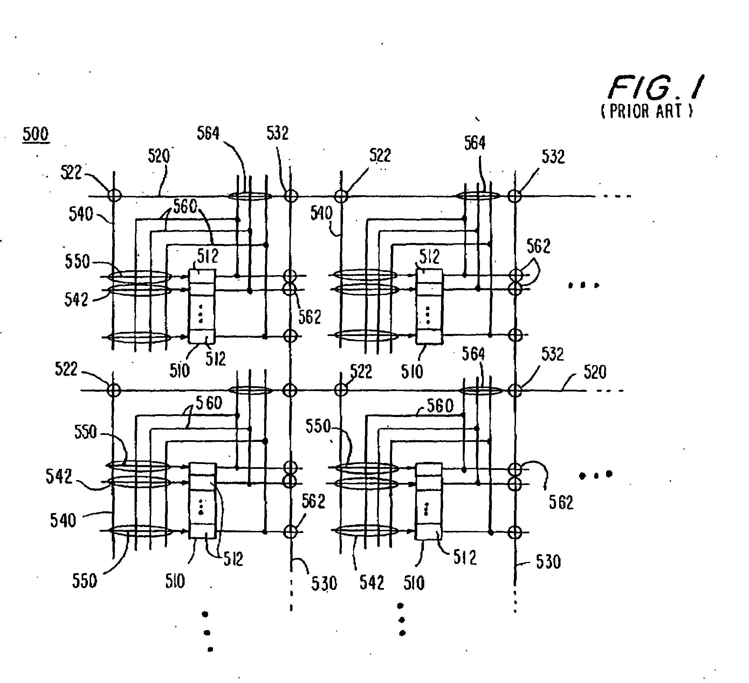

One example of a known programmable logic device 500 is shown in FIG. 1. Device 500 may be generally like the programmable logic devices shown and described in Cliff et al. U.S. patent 5,689,195. Device 500 includes a plurality of regions 510 of programmable logic disposed on the device in a two-dimensional array of intersecting rows and columns of such regions. Each region includes a plurality of subregions 512 of programmable logic. For example, each subregion 512 may include a four-input look-up table which is programmable to produce a "combinatorial" output signal which can be any logical combination of four input signals applied to the look-up table. Each subregion 512 may additionally include a register (e.g., a flip-flop) for selectively registering (storing) the combinatorial output signal to produce a registered output signal. And each subregion 512 may include programmable logic connectors ("PLCs") for programmably selecting either the combinatorial or registered output signal as the final output signal of the subregion.

A plurality of horizontal interconnection conductors 520 is associated with each row of regions 510 for conveying signals to, from, and/or between the regions in the associated row. A plurality of vertical interconnection conductors 530 is associated with each column of regions 510 for conveying signals to, from, and/or between the various rows. A plurality of local conductors 540 is associated with each region 510 for making selected signals on the adjacent horizontal conductors 520 available to the associated region. PLCs 522 are provided for making programmable connections between selected intersecting conductors 520 and 540. A plurality of subregion feeding conductors 550 is associated with each subregion 512 for applying selected signals on the adjacent conductors 540 (and adjacent local feedback conductors 560 (described below)) to the associated subregion. PLCs 542 are provided for making programmable connections between intersecting conductors 540/560 and 550. The output signal of each subregion 512 can be applied to selected adjacent vertical conductors via PLCs 562 and/or to selected horizontal conductors 520 via PLCs 564. The output signal of each subregion 512 is also made available as a local feedback signal (via a conductor 560) to all of the subregions in the region 510 that includes that subregion. Selected intersecting horizontal and vertical conductors are programmably interconnectable by PLCs 532.

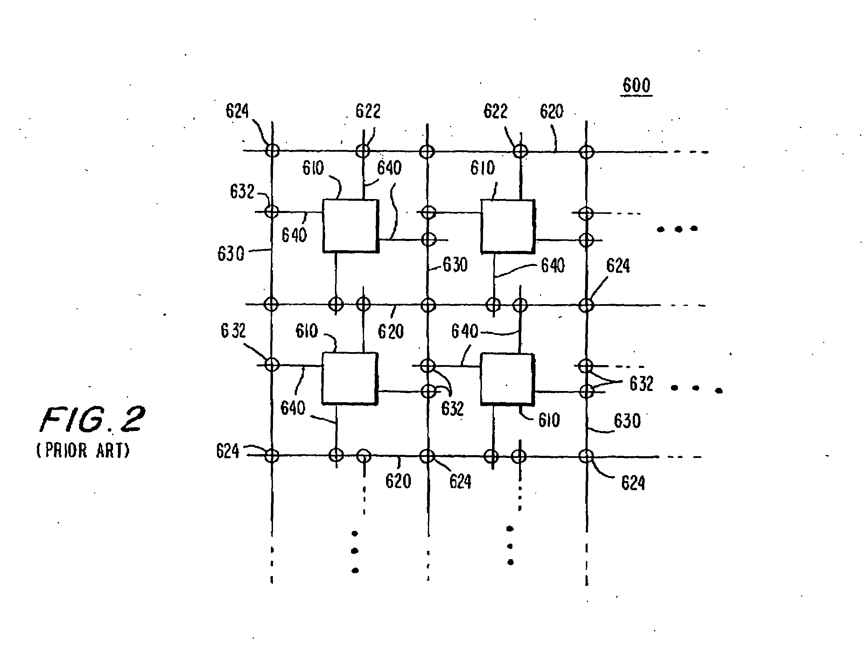

Another example of a known programmable logic device 600 is shown in FIG. 2. Device 600 may be generally like the programmable logic devices shown in Freeman U.S. patent Re. 34,363, which is also hereby Device 600 includes a plurality of configurable logic blocks ("CLBs") 610 disposed on the device in a two-dimensional array of intersecting rows and columns of CLBs. Each CLB 610 may include one or two small, programmable, look-up tables and other circuitry such as a register and PLCs for routing signals within the CLB. A plurality of horizontal interconnection conductor tracks 620 are disposed above and below each row of CLBs 610. A plurality of vertical interconnection conductor tracks 630 are disposed to the left and right of each column of CLBs 610. Local conductors 640 are provided for bringing signals into each CLB 610 from selected conductor tracks 620/630 adjacent to each side of the CLB and/or for applying signals from the CLB to selected adjacent conductor tracks 620/630. PLCs 622/632 are provided for making programmable connections between selected intersecting conductors 620/630 and 640. PLCs 624 are provided for making programmable connections between selected conductors segments in tracks 620 and/or 630 that intersect or otherwise come together at the locations of those PLCs.

In programmable logic devices such as those shown in FIGS. 1 and 2, first-in/first-out ("FIFO") chains of static random access memory .("SRAM") cells are commonly used on the device for programmable control of the configuration of the device. For example, the SRAM cells in such FIFO chains may be used to control the logic performed by each subregion 512 or CLB 610 (e.g., by constituting or controlling the data stored in the look-up tables in those components and by controlling the connections made by the PLCs in those components). The SRAM cells in the FIFO chains may also be used to control the connections made by the various interconnection conductor PLCs (e.g., PLCs 522, 532, 542, 562, 564, 622, 624, and 632) on the device. A typical prior art FIFO SRAM chain 10 will now be described with reference to FIG. 3.

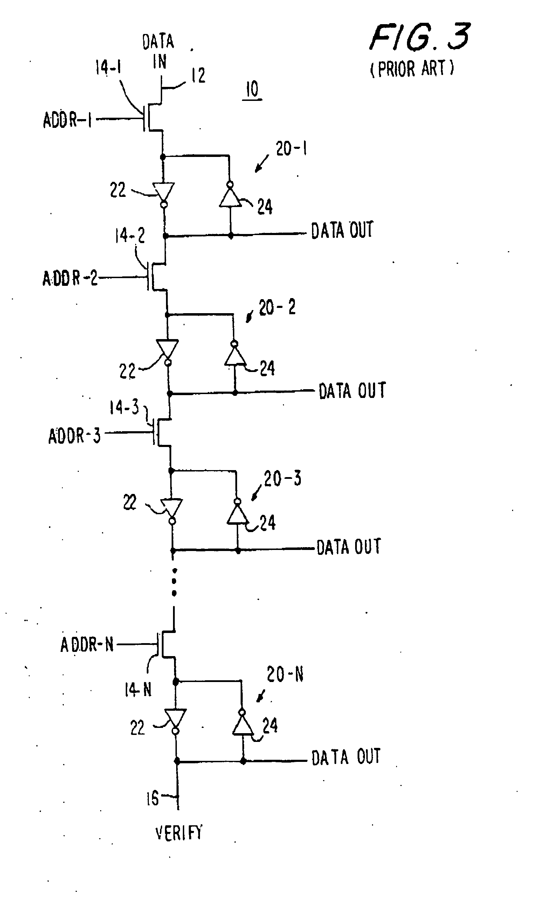

In the FIFO SRAM chain 10 shown in FIG. 3, each SRAM cell 20 includes a relatively strong, forwardly directed inverter 22 connected in a closed loop series with a relatively weak, backwardly directed inverter 24. In the absence of a signal passed from above by an NMOS pass gate 14, each inverter 24 is strong enough to hold the associated inverter 22 in whatever state it was left by the most recent signal passed by the pass gate 14 immediately above. On the other hand, each inverter 24 is not strong enough to prevent the associated inverter 22 from responding to any signal passed by the pass gate 14 immediately above.

Programming data is applied to FIFO chain 10 via DATA IN lead 12 at the start of the chain. Initially all of pass gates 14 are enabled by address signals ADDR-1 through ADDR-N. This allows the first programming data bit to pass all the way down the chain (inverted by each successive inverter 22 that it passes through) until it reaches and is stored in cell 20-N. Pass gate 14-N is then turned off by changing the ADDR-N signal to logic 0. The next programming data bit from lead 12 therefore passes down the chain until it reaches and is stored in the cell immediately above cell 20-N (not shown but similar to all other cells 20). The NMOS pass gate 14 above the cell above cell 20-N is then turned off and the next programming data bit is applied to lead 12. This process continues until all of cells 20 have been programmed and all of pass gates 14 have been turned off. Each cell 20 outputs the data it stores via its DATA OUT lead. These DATA OUT signals may be used to control various aspects of the operation of a programmable logic device that includes chain 10. For example, a DATA OUT signal from chain 10 may control a programmable aspect of the "architecture" of the programmable logic device (e.g., which of several available clock or clear signals a register in a subregion 512 (FIG. 1) or a CLB 610 (FIG. 2) responds to). Or a DATA OUT signal from chain 10 may control a programmable aspect of the logic performed by the device (e.g., by being a datum in a look-up table in a subregion 512 or a CLB 610). As still another example, a DATA OUT signal from chain 10 may control an interconnection conductor PLC (e.g., a . PLC 522, 532, etc. (FIG. 1), or a PLC 622, 624, etc. (FIG. 2)) on the device.

The contents of chain 10 may be verified by using the ADDR signals to enable pass gates 14 progressively from the bottom up. This allows the data in cells 20 to be read out one after another from the bottom up via VERIFY lead 16.

It will be apparent from the foregoing that in order to program or verify chain 10 each NMOS pass gate 14 must be able to effectively pass both logic 0 and logic 1 signals. When circuit components are made very small (as is becoming possible as a result of ongoing advances in the techniques for semiconductor fabrication) and VCC (the power voltage used for logic 1 signals) is accordingly reduced, an NMOS pass gate 14 may not be able to pass a logic 1 signal that is sufficiently strong to overwrite the logic 0 output of the inverter 24 below it unless the pass gate is made undesirably large. Any unipolar MOS (i.e., NMOS or PMOS) pass gate will have this or a similar problem in these circumstances. Thus a PMOS pass gate does not pass logic 0 very well under the above-described conditions that reduce the effectiveness of an NMOS pass gate in passing logic 1. FIFO SRAM chains are therefore becoming less satisfactory for use as the programmable elements in products such as programmable logic devices.

In view of the foregoing, it is an object of this invention to provide improved SRAMs for use on programmable logic devices or in other similar contexts.

It is a more particular object of this invention to provide SRAMs that can be used on programmable logic devices that are made using advanced integrated circuit fabrication techniques and therefore with extremely small circuit components and/or with the intention of using relatively low VCC potential.

US5325325 discloses a semiconductor memory device capable of initializing storage data.

US5361232 discloses an apparatus and method for testing static RAM memory circuits. During test mode, a test signal is provided on the readout bus along with current from the memory cell. If one of the secondary transistors in the memory cell is weak, then the primary transistor is without a good current source and the memory cell is pulled down by the testing transistors 40 or 42 and is caused to switch to a failing state.

US5561631 discloses a programmable logic device which performs a self test erase check operation on memory elements to verify if the programmable logic device is complete erased. In the system disclosed in US5561631, the memory cells associated with an entire word line of the PLD memory array are simultaneously checked for an erased state by bringing the word line under test high while keeping all other word lines low.

### Disclosure of the Invention

According to one aspect, the invention comprises a programmable logic array as defined in claim 1.

According to another aspect, the invention comprises a method for storing information in a plurality of SRAM memory cells on a programmable logic device as defined in claim 8.

The memory cells comprise SRAM cells, all of which store a first of two logic states when the SRAM is initialized, and which are individually or specifically addressed during programming mode when it is desired to change the state of an addressed cell to the second of the two logic states. In addition, the address connection of each cell is such that the cell is changed to the second logic state by passing a logic 0 signal through an NMOS pass gate to the cell, or by passing a logic 1 signal through a PMOS pass gate to the cell. Even NMOS pass gates that are too small to reliably pass logic 1 signals pass logic 0 signals perfectly satisfactorily. Similarly, even PMOS pass gates that are too small to reliably pass logic 0 signals pass logic 1 signals satisfactorily.

The data input terminal of each SRAM cell can also be used to verify the contents of the cell after programming. To verify a cell's contents, a lead that is used to supply data to the cells during programming is charged to the second logic state and then weakly held at that potential. The cell to be verified is then addressed to connect the data input terminal of the cell to the above-mentioned data input lead. If the cell has the first logic state, the cell will not try to discharge the data input lead, which will therefore remain at the second logic potential. On the other hand, if the cell is at the second logic potential, the cell will gradually discharge the data input lead to the first logic potential (although the cell itself will not change from the second logic state to the first logic state). Thus the potential on the data input lead after the foregoing operations can be used to verify the contents of the SRAM cell being tested.

Further features of the invention, its nature and various advantages will be more apparent from the accompanying drawings and the following detailed

### description of the preferred embodiments.

### Brief Description of the Drawings,

FIG. 1 is a simplified schematic block diagram of a representative portion of illustrative conventional programmable logic device circuitry with which this invention can be used.
FIG. 2 is similar to FIG. 1, but for another example of conventional programmable logic device circuitry with which the invention can be used.
FIG. 3 is a simplified schematic diagram of a conventional FIFO SRAM chain.

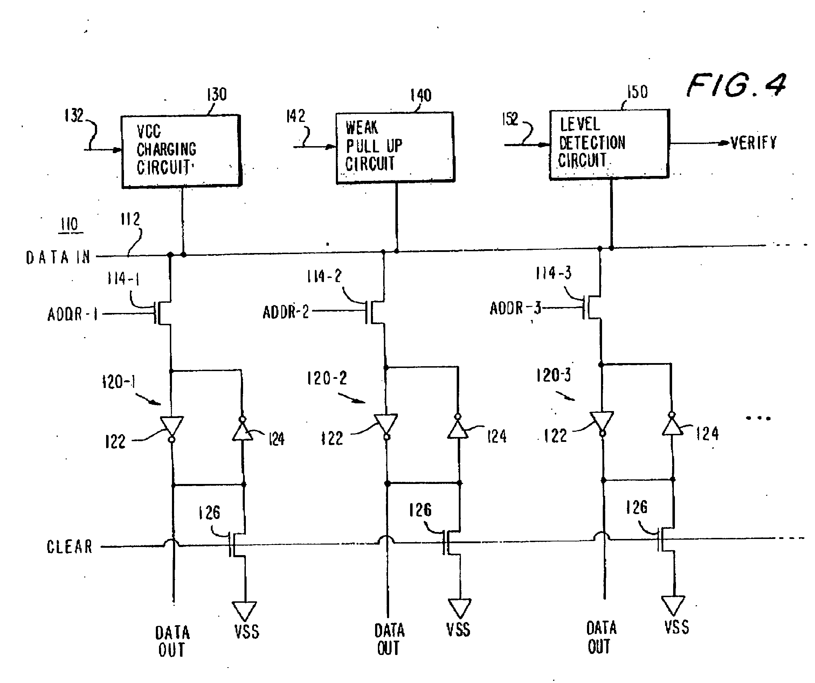

FIG. 4 is a simplified schematic block diagram of representative portions of an illustrative embodiment of an SRAM constructed in accordance with this invention.

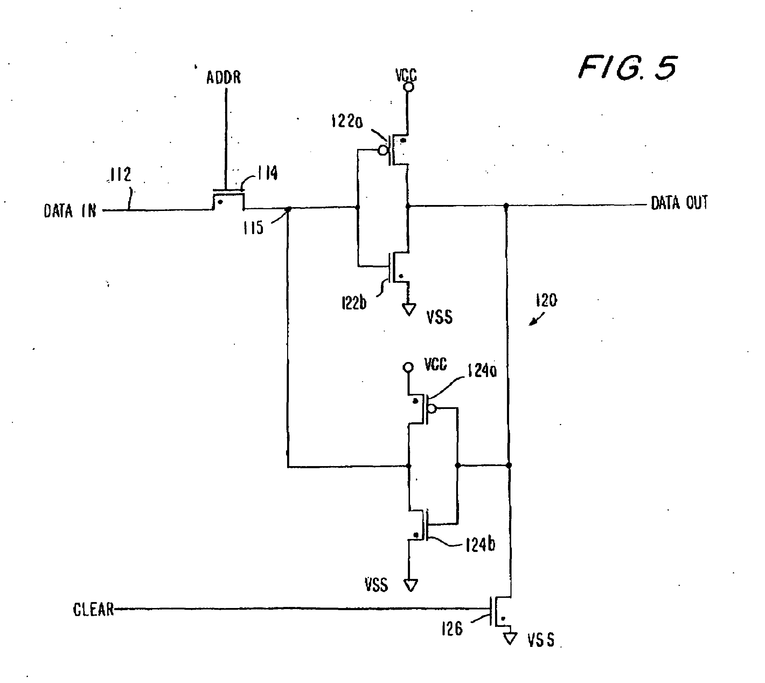

FIG. 5 is a more detailed schematic diagram of an illustrative embodiment of a representative portion of the circuitry shown in FIG. 4.

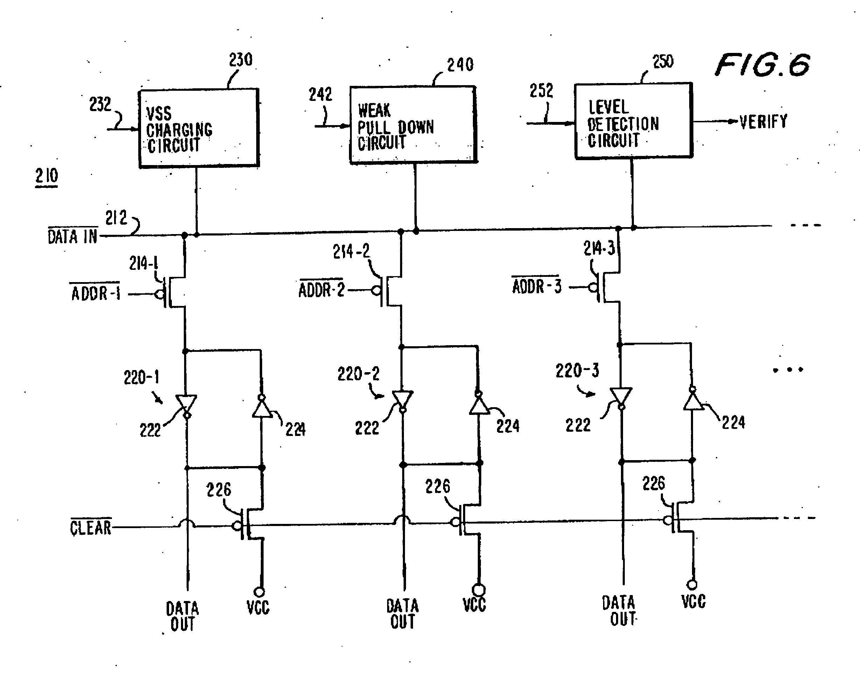

FIG. 6 is a diagram similar to FIG. 4 showing an alternative illustrative embodiment of an SRAM constructed in accordance with the invention.

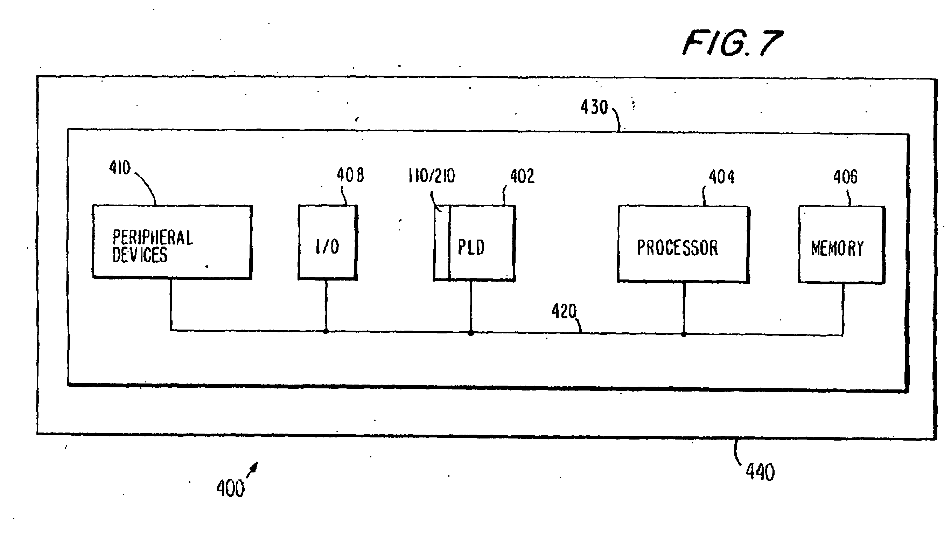

FIG. 7 is a simplified block diagram of an illustrative embodiment of a system which includes a programmable logic device configured by an SRAM of this invention, all in accordance with the invention.

### Detailed Description of the Preferred Embodiments

A representative portion of an illustrative embodiment of SRAM circuitry 110 in accordance with this invention is shown in FIG. 4. SRAM circuitry 110 includes any desired number of SRAM cells 120, each of which is selectively connectable to a common DATA IN lead 112 via a respective NMOS pass gate 114. Each SRAM cell 120 includes a relatively strong inverter 122 connected in a closed loop series with a relatively weak inverter 124. A more detailed circuit diagram of a representative SRAM cell 120 is shown in FIG. 5 and described later in this specification. The output terminal of each SRAM cell's strong inverter 122 is the DATA OUT lead of that cell. Assuming that SRAM circuitry 110 is included on a programmable logic device, the DATA OUT signals of that circuitry can be used in any way that.the DATA OUT signals in FIG. 3 can be used to programmably control various aspects of the connectivity and operation (generically the "configuration") of the programmable logic (e.g., as described above in connection with FIGS. 1-3 for the illustrative programmable logic device organizations shown in FIGS. 1 and 2). The DATA OUT terminal of each SRAM cell is also selectively connectable to VSS (logic 0 (ground)) via an associated NMOS pass gate 126. All of gates 126 are enabled in parallel by a logic 1 signal applied to the CLEAR lead. VCC charging circuit 130, week pull up circuit 140, and level detection circuit 150 are used only during operation of the circuitry to verify the contents of SRAM cells 120. These circuit components are therefore initially inoperative and have no effect on the circuitry.

To program memory circuitry 110 all of pass gates 114 are disabled by logic 0 address signals ADDR-1, ADDR-2, etc. All cells 120 are then cleared by causing the CLEAR signal to go to logic 1. This enables all of pass gates 126, thereby applying logic 0 to the input terminal of the inverter 124 in each cell 120. The resulting logic 1 output of each inverter 124 causes the output of the associated inverter 122 to become logic 0, thereby holding the DATA OUT signal of each cell 120 at logic 0 even after the CLEAR signal returns to logic 0.

After all of cells 120 have been cleared to logic 0 as described above, elements 112 and 114 are used to write logic 1 into only those cells that need to be programmed to logic 1. Logic 0 is applied to DATA IN lead 112. Then logic 1 is applied (sequentially or simultaneously as desired) to the ADDR leads of the pass gates 114 of only those cells 120 that need to be switched from logic 0 to logic 1. Enabling the pass gate 114 of a cell in this way causes the logic 0 signal on DATA IN lead 112 to be applied to the input terminal of that cell's inverter 122. This causes the output terminal of that inverter (and therefore the DATA OUT signal of that cell) to switch to logic 1. The associated inverter 124 operates to hold that inverter 122 in the logic 1 output condition even after the associated ADDR signal switches back to logic 0, thereby disconnecting the memory cell from DATA IN lead 112. This completes the process of programming cells 120.

In actual practice in which the circuitry shown in FIG. 4 is repeated a number of times but with the ADDR signals shared by all the repetitions, it may be necessary, when enabling a particular address line as described above, to apply logic 1 to the DATA IN leads 112 of any repetitions in which the addressed SRAM cells 120 are not to be programmed logic 1. This will prevent inadvertent switching from logic 0 to logic 1 of SRAM cells 120 that are not to be so switched. Structures including repetitions of the FIG. 4 circuitry are discussed in more detail below.

From the foregoing it will seen that all cells 120 are initially cleared to logic 0. Then only those cells requiring programming to logic 1 are addressed and overwritten with logic 1. To do this overwriting, the NMOS pass gates of the cells to be overwritten are only required to pass logic 0, which they do very well even when they are made very small. The circuitry also operates very well with relatively low VCC (logic 1 (power)) voltage or potential, since pass gates 114 are not required to pass logic 1 in order to program cells 120.

After cells 120 have been programmed as described above, their contents can be verified as will now be described. DATA IN lead 112,is first isolated from other signal sources such as the data signal source. VCC charging circuit 130 is then turned on via its control lead 132 to charge lead 112 to logic 1. Circuit 130 is then turned off and weak pull up circuit 140 is turned on via its control lead 142 to apply a weak pull up (logic 1) signal to lead 112. A logic 1 signal is then applied to the ADDR lead of the memory cell 120 whose content is to be verified. This turns on the associated NMOS pass gate 114. If the cell 120 being verified is storing logic 0, the output of that cell's inverter 124 will be logic 1 and there will be no tendency of the voltage on lead 112 to drop from logic 1. On the other hand, if the cell 120 being verified is storing logic 1, the output signal of that cell's inverter 124 will be logic 0, which will cause the voltage on lead 112 to gradually fall from logic 1 toward logic 0. (Under these conditions, the logic 1 signal from lead 112 is not strong enough to change the state of the cell 120 being verified.) Level detection circuit 150 is turned on via its control lead 152 a suitable time'interval after the transistor 114 of the cell being verified is turned on. If the voltage on lead 112 is still logic 1, circuit 150 produces a VERIFY output signal which indicates that the cell being verified is storing logic 0. On the other hand, if the voltage on lead 112 has fallen to logic 0 (or sufficiently far toward logic 0), circuit 150 produces a VERIFY output signal which indicates that the cell being verified is storing logic 1.

The foregoing verification steps are repeated for each cell 120 along line 112 to be verified.

It will be noted that the above-described verification process is not destructive of the data stored in cells 120.

A programmable logic device will typically include several repetitions of the FIG. 4 circuitry (i.e., several parallel DATA IN leads 112 and associated circuitry). The ADDR-1, ADDR-2, etc., signals will be shared by all of these parallel SRAM strings. In particular, one SRAM cell 120-1 in each string will be controlled by a common ADDR-1 signal, another one SRAM cell 120-2 in each string will be controlled by a common ADDR-2 signal, and so on. Thus (as has already been mentioned) when it is desired to program the SRAM cells controlled by any particular address signal, it may be necessary to apply logic 1 to some DATA IN lines 112 to prevent the associated SRAM cells from inadvertently switching from their initial logic 0 output condition.

An illustrative embodiment of a representative SRAM cell 120 is shown in more detail in FIG. 5. Relatively strong inverter 122 is made up of P-channel transistor 122a and N-channel transistor 122b. Relatively weak inverter 124 is made up of P-channel transistor 124a and N-channel transistor 124b. In order for clear pass gate 126 to reset cell 120 to logic 0 as described above, the conductance of transistor 126 should be greater than the conductance of transistor 122a. In order for a logic 0 data signal on lead 112 to cause cell 120 to switch from a reset logic 0 data output to a logic 1 data output as described above, the conductance of transistor 114 should be greater than the conductance of transistor 124a. In order to use lead 112 to verify the contents of cell 120 as described above, the conductance of transistor 124b should be greater than the conductance of transistor 114. This conductance relationship can be satisfied by making transistors 124b and 114 the same size because lower Vgs and body effect decreases the conductance of transistor 114 as the data input terminal 115 of cell 120 begins to rise in voltage.

FIG. 6 shows an alternative embodiment of the FIG. 4 circuitry in which elements 114 and 126 are converted from NMOS pass gates to PMOS pass gates 214 and 226. Other appropriate modifications are also made, but generally similar elements in FIGS. 4 and 6 have their reference numbers increased by 100 in FIG. 6

To program the FIG. 6 circuitry 210 all SRAM cells 220 are preset to logic 1. This is done by applying logic 0 to the CLEAR bar lead. Thereafter, to switch the SRAM cells 220 that need to be switched to logic 0, logic 1 is applied to DATA IN bar lead 212 and logic 0 is applied to the ADDR bar lead for each SRAM cell that needs to be switched. This turns on the PMOS pass gate 214 receiving that ADDR bar signal, thereby allowing that pass gate 214 to pass logic 1 from lead 212. This in turn switches the DATA OUT of the associated SRAM cell 220 to logic 0. Again, assuming that SRAM circuitry 210 is included on a programmable logic device, the DATA OUT signals of that circuitry can be used in any way that the DATA OUT signals in FIGS. 3 and 4 can be used to control the configuration of the associated programmable logic device.

Verification of the contents of SRAM cells 220 is similar to verification of the contents of SRAM cells 120 except that the polarity is reversed. Thus DATA IN bar lead 212 is first charged to logic 0 by VSS charging circuit 230. Then weak pull down circuit 240 is placed in operation to weakly hold lead 212 at logic 0. Next, logic 0 is applied to the ADDR bar lead of the pass gate 214 associated with the SRAM cell whose content is to be verified. If that SRAM cell is outputting logic 1, the inverter 224 in that cell will be outputting logic 0 and there will be no effect on the logic 0 potential of lead 212 as a result of enabling the pass gate 214 between those elements. Level detection circuit 250 will therefore detect no change in the potential of lead 212, and circuit 250 will accordingly produce a VERIFY output signal which indicates that the SRAM cell 220 being verified is storing logic 1. On the other hand, if the SRAM CELL 220 being verified is outputting logic 0, the inverter 224 in that SRAM cell will be outputting logic 1. This will cause the potential on lead 212 to rise when the pass gate 214 associated with that SRAM cell is enabled. This change in the potential on lead 212 is detected by level detection circuit 250, which consequently produces a VERIFY output signal indicating that the SRAM cell being verified is storing logic 0.

FIG. 7 illustrates a programmable logic device 402 (which includes one or more SRAMs 110 or 210 in accordance with this invention for programmable control of the configuration of the programmable logic device) in a data processing system 400. The circuitry of device 402 which is controlled by SRAM(s) 110 or 210 may be organized as shown in FIG. 1 or 2 or in any other desired way. In addition to device 402, data processing system 400 may include one or more of the following components: a processor 404; memory 406; I/O circuitry 408; and peripheral devices 410. These components are coupled together by a system bus 420 and are populated on a circuit board 430 which is contained in an end-user system 440.

System 400 can be used in a wide variety of applications, such as computer networking, data networking, instrumentation, video processing, digital signal processing, or any other application where the advantage of using reprogrammable logic is desirable. Programmable logic device 402 can be used to perform a variety of different logic functions. For example, programmable logic device 402 can be configured as a processor or controller that works in cooperation with processor 404. Programmable logic device 402 may also be used as an arbiter for arbitrating access to a shared resource in system 400. In yet another example, programmable logic device 402 can be configured as an interface between processor 404 and one of the other components in system 400. It should be noted that system 400 is only exemplary, and that the true scope of the invention should be indicated by the following claims.

It will be understood that the foregoing is only illustrative of the principles of the invention, and that various modifications can be made by those skilled in the art without departing from the scope of the invention.

## Claims

1. A programmable logic array comprising:
a plurality of programmable logic blocks;
a plurality of SRAM memory cells (120);
programmable interconnect coupled to the plurality of SRAM memory cells, wherein each SRAM memory cell (120-1, 120-2, 120-3) in the plurality is electrically connected to a common data line (112) for selectively receiving programming information during initial configuration upon asserting an address line (ADDR-1, ADDR-2, ADDR-3) associated with that SRAM memory cell, **characterised in that**
each SRAM memory cell is electrically connected to a predetermined voltage for resetting that memory cell prior to initial configuration upon asserting a clear line (CLEAR); and
**in that** the programmable logic array further comprises a verification circuit (150) coupled to the SRAM memory cells and configured to individually address each one of the SRAM memory cells and verify the programming information stored in each one of the individually addressed SRAM memory cells.

2. The programmable logic array according to claim 1, wherein all the SRAM memory cells (120) in the programmable logic array are reset prior to configuration by a signal on the clear line.

3. The programmable logic array according to claim 1, wherein the common data line (112) is coupled to each SRAM memory cell (120) by a first pass transistor (114) associated with that memory cell.

4. The programmable logic array according to claim 3, wherein each SRAM memory cell (120) includes a first inverter (122) and a second inverter (124), and wherein the first inverter and the second inverter are cross-coupled.

5. The programmable logic array according to claim 4, wherein the first pass transistor (114) is coupled to an associated input of the first inverter (122) and an associated output of the second inverter (124).

6. The programmable logic array according to claim 5, wherein the predetermined voltage is coupled to each SRAM memory cell (120) by a second pass transistor (126) associated with that memory cell.

7. The programmable logic array according to claim 6, wherein the second pass transistor (126) is coupled to an associated output of the first inverter (122) and an associated input of the second inverter (124).

8. A method for storing information in a plurality of SRAM memory cells on a programmable logic device, the method comprising:
providing the plurality of SRAM memory cells on the programmable logic device;
initializing the plurality of SRAM memory cells in response to a reset signal;
receiving configuration information transmitted through a data bus associated with the plurality of SRAM memory cells in response to address signals over an address bus, wherein each SRAM memory cell in the plurality of SRAM memory cells is coupled to the data bus;
**characterised in that** the method further comprises verifying the configuration information stored in the SRAM memory cells by individually addressing each one of the SRAM memory cells; and
selectively updating data contained in the SRAM memory cells in response to the address signals and the information to be stored.

9. The method of claim 8, wherein the verifying of the information includes:
logically disconnecting the SRAM memory cells from the data bus;
charging the data bus to a voltage level that is a predefined voltage potential representing one of two logic states;
maintaining the predefined voltage potential on the data bus;
detecting a change in the voltage level on the data bus in response to the address signals; and
confirming the information stored in each SRAM memory cell in response to the voltage level on the data bus and the address signal associated with the SRAM memory cell being verified.

## Patentansprüche

1. Programmierbares logisches Array, das das Folgende umfasst:
mehrere programmierbare logische Blöcke;
mehrere SRAM-Speicherzellen (120);
programmierbare Verschaltung, die an die mehreren SRAM-Speicherzellen koppelt,
wobei jede der mehreren SRAM-Speicherzellen (120-1, 120-2, 120-3) elektrisch mit einer gemeinsamen Datenleitung (112) verbunden ist, um selektiv Programmierinformationen während einer Anfangskonfigurierung beim Betätigen einer Adressleitung (ADDR-1, ADDR-2, ADDR-3), die mit der SRAM-Speicherzelle verbunden ist, zu erhalten, **dadurch gekennzeichnet, dass**
jede SRAM-Speicherzelle elektrisch mit einer vorbestimmten Spannung verbunden ist, um vor der Anfangskonfiguration die Speicherzelle beim Betätigen einer freien Leitung (CLEAR) zurückzusetzen; und dass das programmierbare logische Array weiter eine Bestätigungsschaltung (150) umfasst, die an die SRAM-Speicherzellen koppelt und konfiguriert ist, um individuell jede der SRAM-Speicherzellen zu adressieren und um die Programmierinformationen, die in jeder der individuell adressierten SRAM-Speicherzelle gespeichert ist, zu verifizieren.

2. Programmierbares logisches Array nach Anspruch 1, wobei alle der SRAM-Speicherzellen (120) in dem programmierbaren logischen Array vor der Konfigurierung durch ein Signal auf der freien Leitung zurückgesetzt werden.

3. Programmierbares logisches Array nach Anspruch 1, wobei die gemeinsame Datenleitung (112) an jede SRAM-Speicherzelle (120) über einen ersten Verbindungs-Transistor (114), der mit der Speicherzelle verknüpft ist, gekoppelt ist.

4. Programmierbares logisches Array nach Anspruch 3, wobei jede SRAM-Speicherzelle (120) einen ersten Inverter (122) und einen zweiten Inverter (124) umfasst, und wobei der erste Inverter und der zweite Inverter über Kreuz gekoppelt sind.

5. Programmierbares logisches Array nach Anspruch 4, wobei der erste Verbindungs-Transistor (114) an einen zugehörigen Eingang des ersten Inverters (122) und an einen zugehörigen Ausgang des zweiten Inverters (124) gekoppelt ist.

6. Programmierbares logisches Array nach Anspruch 5, wobei die vorbestimmte Spannung an jede SRAM-Speicherzelle (120) über einen zweiten Verbindungs-Transistor (126), der mit der Speicherzelle verbunden ist, gekoppelt ist.

7. Programmierbares logisches Array nach Anspruch 6, wobei der zweite Verbindungs-Transistor (126) an einen zugehörigen Ausgang des ersten Inverters (122) und einen zugehörigen Eingang des zweiten Inverters (124) gekoppelt ist.

8. Verfahren zum Speichern von Informationen in mehreren SRAM-Speicherzellen einer programmierbaren logischen Vorrichtung, wobei das Verfahren folgendes umfasst:
Bereitstellen von mehreren SRAM-Speicherzellen auf der programmierbaren logischen Vorrichtung;
Initialisieren der mehreren SRAM-Speicherzellen in Antwort auf ein Rücksetzsignal;
Erhalten von Konfigurationsinformationen, die über einen Datenbus, der mit den mehreren SRAM-Speicherzellen verbunden ist, übertragen werden, und zwar in Antwort auf Adressierungssignale über einen Adressbus, wobei jede SRAM-Speicherzelle aus den mehreren SRAM-Speicherzellen an den Datenbus koppelt;
**dadurch gekennzeichnet, dass** das Verfahren weiter Folgendes umfasst:
Verifizieren der in den SRAM-Speicherzellen gespeicherten Konfigurationsinformationen durch ein individuelles Adressieren jeder der SRAM-Speicherzellen; und
selektives Erneuern von in den SRAM-Speicherzellen enthalten Daten in Antwort auf den Adressierungssignalen und der Information, die zu speichern ist.

9. Verfahren nach Anspruch 8, wobei das Verifizieren von Informationen folgendes umfasst:
logisches Trennen der SRAM-Speicherzellen von dem Datenbus;
Herstellen eines Spannungsniveaus auf dem Datenbusses, das einem vorbestimmten Spannungspotential von einem der beiden logischen Zustände entspricht;
Aufrechterhalten des Spannungspotentials auf dem Datenbus;
Feststellen eines Wechsels in dem Spannungsniveau auf dem Datenbus in Antwort auf die Adressierungssignale; und
Bestätigen der in jeder der SRAM-Speicherzellen gespeicherten Information in Antwort auf das Spannungsniveau auf dem Datenbus und das Adressierungssignal, das mit der zu verifizierenden Speicherzelle verbunden ist.

## Revendications

1. Matrice logique programmable comprenant :
• une pluralité de blocs logiques programmables ;
• une pluralité de cellules de mémoire vive statique (SRAM) (120) ;
• une interconnexion programmable connectée à la pluralité de cellules de mémoire vive statique, dans laquelle chaque cellule de mémoire vive statique (120-1, 120-2, 120-3) parmi la pluralité est électriquement connectée à une ligne de données commune (112) pour recevoir sélectivement l'information de programmation pendant la configuration initiale par assertion d'une ligne d'adresse (ADDR-1, ADDR-2, ADDR-3) associée à cette cellule de mémoire vive statique,
**caractérisée en ce que**
• chaque cellule de mémoire vive statique est électriquement connectée à une tension prédéterminée pour remettre cette cellule de mémoire à zéro avant la configuration initiale par assertion d'une ligne libre (CLEAR) : et **en ce que**
• la matrice logique programmable comporte en outre un circuit de vérification (150) connecté aux cellules de mémoire vive statique et configuré pour adresser individuellement chacune des cellules de mémoire vive statique, et pour vérifier l'information de programmation stockée dans chacune des cellules de mémoire vive statique individuellement adressée.

2. Matrice logique programmable selon la revendication 1, dans laquelle chacune des cellules de mémoire vive statique (120) dans la logique programmable est remise à zéro avant la configuration par un signal sur la ligne libre.

3. Matrice logique programmable selon la revendication 1, dans laquelle la ligne de données commune (112) est connectée à chaque cellule de mémoire vive statique (120) par un premier transistor ballast (114) connecté à cette cellule de mémoire.

4. Matrice logique programmable selon la revendication 3, dans laquelle chaque cellule de mémoire vive statique (120) comprend un premier inverseur (122) et un second inverseur (124), et dans laquelle le premier inverseur et le second inverseur sont interconnnectés.

5. Matrice logique programmable selon la revendication 4, dans laquelle le premier transistor ballast (114) est connecté à une entrée associée du premier inverseur (122) et à une entrée associée du second inverseur (124).

6. Matrice logique programmable selon la revendication 5, dans laquelle la tension prédéterminée est connectée à chaque cellule de mémoire vive statique (120) par un second transistor ballast (126) associé à cette cellule de mémoire.

7. Matrice logique programmable selon la revendication 6, dans laquelle le second transistor ballast (126) est connecté à une entrée associée du premier inverseur (122) et à une entrée associée du second inverseur (124).

8. Procédé pour stocker dans une pluralité de cellules de mémoire vive statique sur un dispositif de logique programmable, le procédé comprenant les étapes suivantes :
• fourniture d'une pluralité de cellules de mémoire vive statique sur le dispositif de logique programmable ;
• initialisation de la pluralité de cellules de mémoire vive statique en réponse à un signal de réinitialisation ;
• réception de l'information de configuration transmise par l'intermédiaire d'un bus de données associé à la pluralité de cellules de mémoire vive statique en réponse aux signaux d'adresse au-dessus d'un bus d'adresses, où chaque cellule de mémoire vive statique dans la pluralité de cellules de mémoire vive statique est connectée au bus de données ;
**caractérisé en ce que** la méthode comprend en outre les étapes suivantes :
• vérification de l'information de configuration stockée dans les cellules de mémoire vive statique en adressant individuellement chacune des cellules de mémoire vive statique ; et
• mise à jour sélective des données contenues dans les cellules de mémoire vive statique en réponse aux signaux d'adresse et à l'information à stocker.

9. Procédé selon la revendication 8, dans lequel la vérification d'information comprend les étapes suivantes :
• déconnexion logique des cellules de mémoire vive statique du bus de données ;
• chargement du bus de données à un niveau de tension qui est un potentiel de tension prédéfini représentant un des deux états de logique ;
• maintien du potentiel de tension prédéfini sur le bus de données ;
• détection d'un changement du niveau de tension sur le bus de données en réponse aux signaux d'adresse; et
• confirmation de l'information stockée dans chaque cellule de mémoire vive statique en réponse au niveau de tension sur le bus de données et les signaux d'adresse liés à la cellule de mémoire vive statique étant vérifiés.
